Europäisches Patentamt

**European Patent Office**

Office européen des brevets

(11) Publication number: **0 197 668**
**B1**

## (12) EUROPEAN PATENT SPECIFICATION

(45) Date of publication of the patent specification: **04.10.89**

(21) Application number: **86301753.9**

(22) Date of filing: **11.03.86**

(51) Int. Cl.⁴: **H01J 37/32,** H05H 1/24

(54) External plasma gun.

(30) Priority: **14.03.85 US 712109**

(43) Date of publication of application:
**15.10.86 Bulletin 86/42**

(45) Publication of the grant of the patent:
**04.10.89 Bulletin 89/40**

(84) Designated Contracting States:
**CH DE FR GB IT LI NL**

(56) References cited:
**JP-A-59 208 726**
**US-A- 4 367 114**
**US-A- 4 501 766**

(73) Proprietor: **Denton Vacuum Inc, 2 Pin Oak Avenue Cherry Hill Industrial Estate, Cherry Hill New Jersey 08003(US)**

(72) Inventor: **Lee, Kon Jiun, 206 Dogwood Manor, Stratford, NJ 08084(US)**
Inventor: **Musset, Anthony, 307 Third Avenue, Haddan Heights, NJ 08035(US)**
Inventor: **Denton, Richard A., 35 Burton Road, Braddocks Mill Lake Marlton, NJ 08053(US)**

(74) Representative: **Michaels, Peter Albert, 34 Marsh Road, Pinner Middlesex HA5 5NQ(GB)**

ACTORUM AG

## Description

The present invention relates to a plasma gun according to claim 1.

Ion beams can be and are used in substrate cleaning, co-deposition of materials, ion assisted deposition, ion milling, ion etching and the like. The present device can be and is advantageously used in any and all of the above mentioned applications.

In the prior art, the technique has been to produce plasma and direct the ions therefrom through a screen (the screen has a voltage which is negative to the plasma body to extract ions from the plasma, to form an ion beam) toward a substrate. This technique has worked reasonably well except that as the ions bombard the substrate, the substrate takes on a positive voltage bias and ions start being repelled by the substrate. The present device acts to provide a plasma external to the gun and this plasma which contains both ions and electrons provides ions for the ionic actions, but provides electrons to neutralize the positive charge on the substrate from the ion bombardment thereby mitigating the repelling effect.

The present device is a mechanism for producing a plasma body, or plasma cloud, external to the mechanism. The external plasma body can be directed, shaped and concentrated by electrodes or magnetic fields placed outside of the exit aperture plate. In a preferred embodiment, the device employs a permanent magnet, which is substantially doughnut shaped. The inside surface of the doughnut shaped magnet is concave shaped so that magnetic flux passes from one end of the concave shaped inside surface to the other end of the concave shaped surface. An enclosure is formed between the magnetic flux and the inside concave shaped surface. An anode is located in the enclosure so that the electrons are impeded from directly striking the anode. By inhibiting the electrons from passing to the anode the ionization process is more effective and the plasma which is generated is dense. The device, of course, has a cathode and the cathode is formed to fit over one end of the aperture formed through the doughnut. In a preferred embodiment every conducting body other than the anode is part of the cathode although throughout the description the cathode will be described as the plate means located at the end of the doughnut shaped magnet opposite the exit plate. When the cathode is connected to a negative voltage and the anode is connected to a positive voltage there is an electrostatic field developed therebetween. Over the end of the doughnut aperture, opposite the cathode, there is fitted an exit aperture plate. Over a substantial portion of the cathode surface which is exposed to the aperture within the doughnut, there is located a baffle. Ionizable gas is passed through the cathode and dispersed around the baffle and directed to uniformly enter the plasma chamber between the anode and said concave inside surface. The action of uniformly passing the ionizable gas into the plasma chamber from behind the anode aids in causing an efficient generation of a dense plasma. The plasma is generated, in response to the presence of the ionizable gas and the crossed electrostatic and magnetic fields, in the plasma chamber and in addition parts of the plasma exist outside the large aperture in the plasma exit plate, i.e., a plasma body exists external to the gun.

The object and features of the present invention will be better understood when the following description is studied along with the drawings wherein:

Figure 1 is a sectional side view of the plasma gun; and

Figure 2 is a pictorial schematic of the plasma gun.

Figure 3 is a voltage-time graph to help explain the technique of varying the speed of the ions.

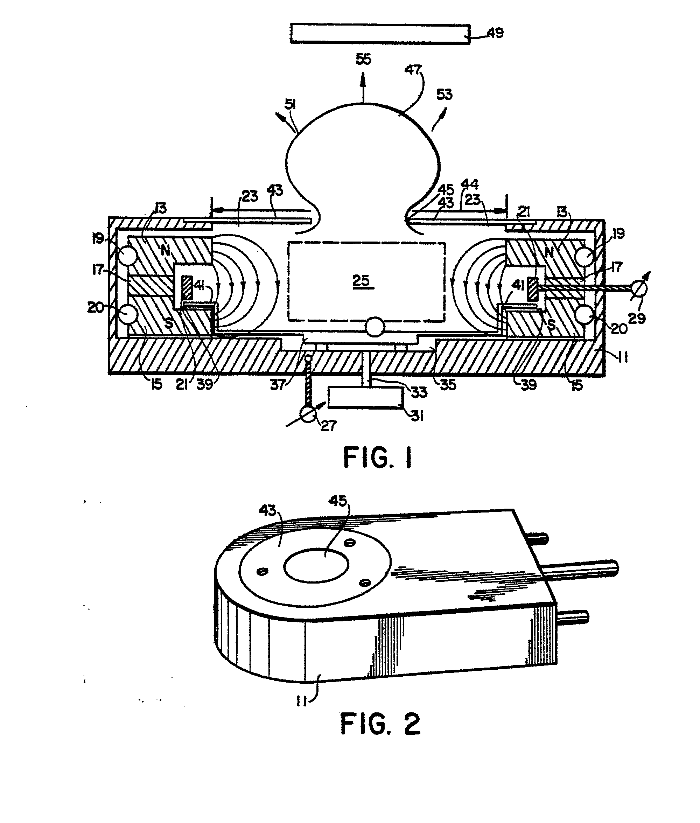

Consider Figure 1. In Figure 1 there is shown in cross section a housing 11. The housing 11 is fabricated from aluminum or other suitable non-magnetic electrically conducting material. In a preferred embodiment the toroidal section has a 10 cm inside diameter and is 5 cm high. Within the housing 11, there are located two ring shaped magnetizable members 13 and 15. While the members 13 and 15 are ring shaped in the preferred embodiment they could be simply an endless shaped member such as an oblong shaped device. The two magnetizable members 13 and 15, in a preferred embodiment are fabricated from easily magnetized material such as soft iron. The two magnetizable rings 13 and 15 are connected by a plurality of insert magnets 17 having their north and south poles oriented to provide for flux generated as shown by flux 23. It should be understood that the insert magnets could have the polarities oriented in the opposite direction. It should also be understood that the flux is considered to be substantially parallel with the axis of the toroidal section and while an oblong section may not have an axis the flux would be considered nonetheless passing substantially parallel to the aperture normal.

As can be further gleaned from Figure 1, wound around the magnetizable members 13 and 15 are two water cooling pipes 19 and 20. The water cooling pipes 19 and 20 are connected to a suitable cold water source, so that the water can be pumped therethrough to maintain the gun in a cooled state. Both the cathode and anode heat up to some extent even though the system is considered a cold cathode system. The cathode does not become thermionic, although it should be understood the present device can work with a hot cathode installation. The generation of magnetic flux is well understood in the art and any suitable magnetic flux generating means could be used provided it meets the obvious constraints of the present device, such as providing the flux in such form that it can be used to shield the anode from the plasma as will be explained in more detail hereinafter. It should also be understood that forms of cooling fluids other than water could be used.

It will be noted in Figure 1 that the location and shape of the rings 13 and 15 cause the magnetic flux generating means to assume the shape of the letter "C." To say it another way, the inside surface of the magnetic flux generating means is shaped concave. Within the concave configuration there is located an anode element 21. The anode 21 is ring shaped and suitably mounted and electrically isolated from the magnetic flux generating means. It becomes apparent that when the magnetic flux generating means is generating flux, the flux takes the shape of the flux 23 and acts to shield the anode 21. In other words the flux 23 forms an enclosure with the concave configuration of the inside surface of the magnetic flux generating means. The anode 21, being within that enclosure, is shielded from the electrons, i.e., the electrons are impeded from directly striking the anode. The base of the housing 11 acts as part of the cathode structure and is connected to a variable direct current potential source 27 which is always held negative with respect to the anode. The variable potential source 27 can be any well known variable d.c. source of electrical energy. The cathode is held at a voltage which is negative with respect to the anode 21. In some applications the cathode is held negative with respect to ground while in other applications it is held positive with respect to ground. The anode 21 is connected through the array of insert permanent magnets 17 and through the housing 11 to a variable source of voltage 29. The voltage source 29 can be any well known variable d.c. source of electrical energy and is held positive with respect to the cathode.

When suitable electrical power is applied between the sources 27 and 29 there is an electrostatic field created between the anode and the cathode and the stage is set for the introduction of an ionizable gas such as nitrogen, argon, or oxygen. The ionizable gas is supplied from a source of gas 31, through the housing 11, by virtue of the channel 33, into a conduit 35. The gas conduit 35 is formed by the baffle 37 and the housing 11. As can be seen in Figure 1, the baffle 37 is step shaped so that its final opening 39 is in close proximity to the anode 21. The gap between the anode 21 and baffle 37 is of appropriate size to prevent arcing thereacross. It should be understood that this baffle 37 is circular shaped so that the gas conduit 35 directs the gas to the edge of the shielded enclosure, behind the ring shaped anode 21. We have found that if the gas is delivered uniformly around the edge of the shielded enclosure and then passed into the plasma chamber, the efficiency of production and the density, of the plasma is improved. We have found that if the baffle were to terminate at the first step point, i.e., point 41, the efficiency and density are improved over simply passing gas directly into the chamber from one or more orifices.

When the ionizable gas has been passed through the conduit 35, into the chamber, a plasma will be generated and there will be collisions between molecules of gas, and ions, and electrons. The magnetic shielding of the anode causes the electrons to orbit and the plasma is then confined and dense. Heretofore a negatively charged grid has been employed and located between the substrate and the plasma phenomenon. In this prior art arrangement ions and electrons headed for the outside world from the plasma chamber with the electrons, in great number, being repelled by the charged grid and many of the ions passing through the grid to bombard the substrate. In the present device there is an exit aperture plate, located on the top end of the chamber, i.e., the upper end of the aperture in the magnetic flux generating device. In a preferred embodiment the exit aperture plate has an aperture 45 of 3 cm. The aperture diameter can vary to some degree. The range of the diameter of the aperture 45 is from 15% to 60% of the diameter of the aperture 44, i.e., the aperture of the doughnut shaped magnetic flux generating means. The aperture 45 must be small enough to maintain a large pressure difference. On the other hand, it cannot be so small that it would inhibit the generation of the external plasma. The aperture size is dependent to some degree on the gas used, the electrostatic field generated and the intended application. In any event, when compared to the spaces in grids of the prior art, aperture 45 is a substantially large aperture.

When the plasma is generated in the plasma chamber 25, which generation occurs instantaneously upon application of electrical power, the plasma extends through the aperture 45 into a configuration shown in Figure 1.

The plasma body 47 is composed of electrons and ions and energetic neutrals. The external plasma 47 is directed to a substrate, such as a substrate 49 which is bombarded by ions, electrons and neutrals. We have found a number of useful applications with the external plasma as compared with the prior art ion gun. For instance we have found that the uniformity of substrate etching to be very much enhanced when using the present device as compared to a prior art ion gun. We believe that the inclusion of the electrons in the plasma serves to neutralize the charge after the ions have come to rest in or on the substrate and hence the substrate does not build up a positive charge to repel incoming ions. We have found that in some modes of operation the external plasma has a predominance of ions in one section thereof and a predominance of electrons in another section thereof. This feature is useful where there is a requirement to periodically neutralize a moving substrate or there is a requirement to alternately effect ion and electron bombardment of a substrate.

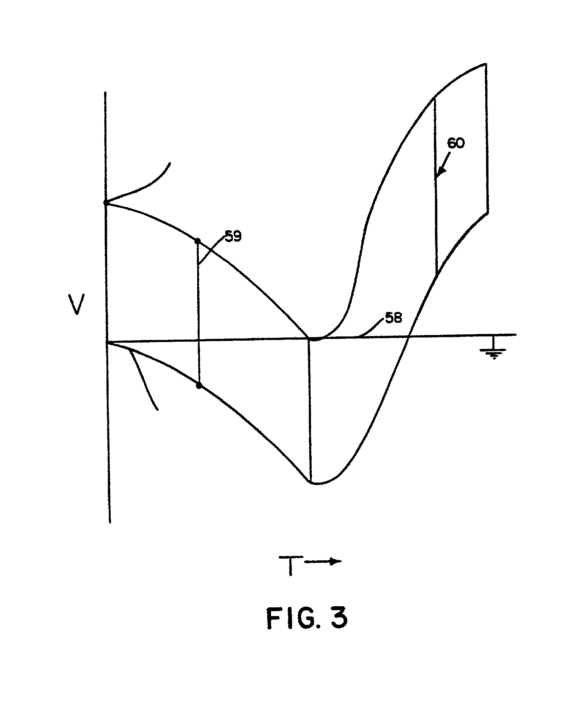

The present plasma gun is useful where there is a requirement to reduce the energy of the ions so that the bombardment of the substrate is moderated. It should also be understood that in some applications we may wish to increase the energy of the ions. If we examine Figure 3, in this part of the description, it will become more meaningful. In Figure 3 there are shown two voltage curves, one being the voltage on the anode and the other being the voltage on the cathode. If we recognize that the horizontal line 58 is at ground potential and that the abscissa is time, then we find that as we vary the anode voltage and the cathode voltage (but keep their difference constant) the current in the plasma will remain constant. The energy with which the ions strike the substrate is directly related to the difference between the anode voltage and ground potential. By keeping the difference between the cathode voltage and the anode voltage constant, we maintain a dense plasma in area 25. By arranging the voltages to be at position 59 in the graph we have reduced the energy with which the ions strike the substrate 49 (Figure 1). Correspondingly by arranging the voltages to be at position 60, we have increased the energy of the ions. This ability of the present device, i.e., to accelerate and decelerate the ion energy, is useful for instance in a case where ion bombardment from the gun is employed during thin film deposition to supply energy to the film as it deposits, thereby improving film structure.

In addition, in other modes of operation we have found that the external plasma produces a beam predominantly of ions and this ion beam can be of extremely uniform density. Empirically we have determined that said ion beam measured in a horizontal substrate plane, 55 cm above the source aperture maintains a uniformity of beam density on a substrate diameter of 100 cm to within 2.5% of the mean density. It has also been observed that uniformity of density is readily accomplished by holding the difference of potential between the cathode and anode constant and holding the cathode potential approximately at ground.

Figure 2 depicts a pictorial view of one embodiment of the plasma gun. Even though the right hand end is rectangularly shaped, the elements shown in Figure 1 are housed in the left hand end and are as described above. The rectangularly shaped section accommodates wiring, water cooling pipes and pipes from the ionizable gas source. It should be understood that the exit aperture plate 43 is easily removable by removing the three screws shown. A variety of plates can be used with different sized apertures to accommodate different applications. It should be further understood that a plurality of magnetic devices along with their associated anodes can be stacked one upon another and fitted within a single housing to provide a plasma chamber of greater depth than the plasma chamber shown in Figure 1.

## Claims

1. A plasma gun comprising magnetic flux generating means, said magnetic flux generating means having an endless configuration, an inside surface and an outside surface and an aperture therethrough with said magnetic flux oriented substantially parallel to the axis of said aperture, said aperture having first and second ends and being defined by said inside surface, said inside surface having a concave configuration and first and second ends whereby said magnetic flux passes from said first end of said concave configuration to said second end of said concave configuration thereby creating an enclosure between said magnetic flux and said inside surface, anode means disposed within said enclosure and adapted to be connected to a first electrical voltage, cathode means formed to fit over said first end of said aperture and adapted to be connected to a second voltage, plate means, having at least one substantially large aperture therein, formed to fit over said second end of said aperture in said magnetic flux generating means and means to enable ionizable gas to be fed into a plasma chamber formed by said plate means, said cathode means and said magnetic flux generating means whereby when said first and second electrical voltage are respectively connected to said anode means and to said cathode means, in the presence of an ionizable gas, a dense plasma is generated which causes plasma to exist external to said plate means as well as in said plasma chamber.

2. A plasma gun according to Claim 1 wherein said means to enable ionizable gas to be fed into said plasma chamber includes a channel means passing from outside said gun to said plasma chamber and a baffle formed to substantially cover said first end of said aperture of said magnetic flux generating means and disposed so that between said baffle and said cathode there is formed a gas conduit which directs gas to be fed into said plasma chamber uniformly from around the periphery of said plasma chamber.

3. A plasma gun according to Claim 1 wherein said plate means is formed to be easily removable and therefore easily interchangeable with other plate means having different sized apertures from one another.

4. A plasma gun according to Claim 1 wherein said first and second electrical voltage means are each variable voltage sources and wherein said first and second voltage means can be independently varied to maintain a dense plasma in said plasma chamber while at the same changing the energy of ions included in said external plasma.

5. A plasma gun according to Claim 1 wherein said magnetic flux generating means includes at least one permanent magnet.

6. A plasma gun according to Claim 1 wherein there is further included a housing means and wherein said cathode means is part of said housing means.

7. A plasma gun according to Claim 4 wherein the difference between said first and second voltage is held substantially constant and wherein said second voltage is held at approximately ground whereby there results an ion beam having extremely uniform density.

8. A plasma gun according to Claim 1 wherein there is provided a substrate above the at least one aperture in said plate means.

## Patentansprüche

1. Kanone für Plasma mit einem Magnetfluß erzeugenden Hilfsmitteln, die eine endlose Anordnung, eine Innenfläche, eine Außenfläche und eine Durchgangsöffnung besitzen, zu deren Achse der Magnetfluß im wesentlichen parallel gerichtet ist, wobei die Öffnung zwei Enden aufweist und durch die Innenfläche definiert ist, die eine konkave Gestalt und zwei Enden besitzt, und wobei der Magnetfluß von dem ersten Ende der konkaven Gestalt zum zweiten Ende der konkaven Gestalt hindurchgeht und dadurch einen Einschluß zwischen dem Magnetfluß und der Innenfläche hervorruft, mit Anoden, die innerhalb des Einschlusses untergebracht und an einer ersten elektrischen Spannung anschließbar sind, mit derart ausgebildeten Kathoden, daß sie über das erste Ende der Öffnung passen und an einer zweiten Spannung anschließbar sind, mit wenigstens eine im wesentlichen umfangreiche Öffnung enthaltenden, derart geformten Platten, daß sie über das zweite Ende der Öffnung in den einen Magnetfluß erzeugenden Hilfsmitteln passen, und mit Hilfsmitteln, von denen ein ionisierbares Gas in eine Plasmakammer einspeisbar ist, die von den Platten, den Kathoden und den einen Magnetfluß erzeugenden Hilfsmitteln gebildet ist, wodurch beim Anlegen der ersten bzw. zweiten elektrischen Spannung an die Anoden bzw. die Kathoden in Gegenwart eines ionisierbaren Gases ein dichtes Plasma erzeugt wird, das ein außerhalb der Platten sowie in der Plasmakammer vorhandenes Plasma verursacht.

2. Kanone für Plasma gemäß Anspruch 1, bei der die Hilfsmittel, von denen ein ionisierbares Gas in die Plasmakammer einspeisbar ist, einen von außen in die Plasmakammer der Kanone laufenden Kanal und ein derart geformtes Leitstück enthalten, daß das erste Ende der Öffnung der einen Magnetfluß erzeugenden Hilfsmittel im wesentlichen bedeckt wird, wobei das Leitstück derart untergebracht ist, daß zwischen ihm und der Kathode eine Gasleitung gebildet ist, die ein in die Plasmakammer einzuspeisendes Gas gleichförmig rund um die Peripherie der Plasmakammer zuleitet.

3. Kanone für Plasma gemäß Anspruch 1, bei der die Platten leicht entfernbar und daher leicht gegen andere Platten austauschbar sind, die untereinander unterschiedlich große Öffnungen aufweisen.

4. Kanone für Plasma gemäß Anspruch 1, bei der die erste und zweite elektrische Spannung jeweils von veränderbaren Spannungsquellen heranführbar ist, und bei der die erste und zweite Spannung unabhängig veränderbar ist, um in der Plasmakammer ein dichtes Plasma aufrechterhalten wird, während sich dennoch die Energie der im äußeren Plasma eingeschlossenen Ionen ändert.

5. Kanone für Plasma gemäß Anspruch 1, bei der die einen Magnetfluß erzeugenden Hilfsmittel mindestens einen Permanentmagneten enthalten.

6. Kanone für Plasma gemäß Anspruch 1, in der ferner ein Gehäuse enthalten ist, und bei der die Kathode einen Teil des Gehäuses bildet.

7. Kanone für Plasma gemäß Anspruch 4, bei der die Differenz zwischen der ersten und zweiten Spannung im wesentlichen konstant gehalten wird, und bei der die zweite Spannung annähernd auf dem Erdpotential gehalten wird, wodurch sich ein Ionenstrahl mit einer äußerst gleichförmigen Dichte ergibt.

8. Kanone für Plasma gemäß Anspruch 1, bei der oberhalb der mindestens einen Öffnung in den Platten eine Unterlage vorgesehen ist.

## Revendications

1. Pistolet à plasma comprenant des moyens générateurs de flux magnétique (13, 15, 17) qui présentent une configuration sans fin avec une surface intérieure, une surface extérieure et une ouverture traversante (44), ledit flux magnétique (23) étant orienté dans une direction sensiblement parallèle à l'axe de ladite ouverture (44), cette ouverture (44) présentant une première et une seconde extrémités et étant définie par ladite surface intérieure, cette surface intérieure ayant une configuration concave avec une première et une seconde extrémités, ledit flux magnétique (23) passant de la première extrémité de cette configuration concave à la seconde extrémité de la configuration concave et créant ainsi une enceinte entre le flux magnétique et ladite surface intérieure, des moyens anodiques (21) disposés dans cette enceinte et agencés de façon à être connectés à la source d'une première tension électrique (29), des moyens cathodiques réalisés de façon à s'adapter sur ladie première extrémité de ladite ouverture (44) et agencés de façon à être connectés à la source d'une seconde tension (27), un diaphragme (43) dans lequel est formée au moins une ouverture de grande taille (45) et qui est réalisé de façon à s'adapter sur ladite seconde extrémité de ladite ouverture (44) des moyens générateurs de flux magnétique (13, 15, 17), et des moyens (31–39) pour permettre qu'un gaz ionisable soit introduit dans une chambre de plasma (25) formée par le diaphragme (43), par les moyens cathodiques et par les moyens générateurs de flux magnétique (13, 15, 17), d'où il résulte que quand lesdites première et seconde tensions électriques sont appliquées respectivement aux moyens anodiques et aux moyens cathodiques, en présence d'un gaz ionisable, il est produit un plasma dense et que du plasma existe à l'extérieur dudit diaphragme (43) aussi bien que dans ladite chambre de plasma (25).

2. Pistolet à plasma selon la revendication 1, dans lequel lesdits moyens pour permettre qu'un gaz ionisable soit introduit dans ladite chambre de plasma (25) comprennent un conduit (33, 35) qui s'étend entre l'extérieur du pistolet et ladite chambre de plasma (25) et une chicane (37) réalisée de manière à recouvrir pratiquement ladite première extrémité de ladite ouverture (44) des moyens générateurs de flux magnétique (13, 15, 17) et disposée de telle façon qu'il soit formé, entre cette chicane (37) et la cathode (11), un passage de gaz (35) qui dirige le gaz pour qu'il soit introduit uniformément dans ladite chambre de plasma (25) par toute la périphérie (39) de cette chambre.

3. Pistolet à plasma selon la revendication 1, dans lequel le diaphragme (43) est réalisé de façon à être facilement amovible et, en conséquence, facilement interchangeable avec d'autres diaphragmes présentant des ouvertures (45) de tailles mutuellement différentes.

4. Pistolet à plasma selon la revendication 1, dans lequel lesdites première et seconde sources de tension électrique (29, 27) sont des sources de tension variable et dans lequel il est possible de faire varier indépendamment lesdites première et seconde tensions pour maintenir un plasma dense dans ladite chambre de plasma (25), tout en modifiant l'énergie des ions contenus dans ledit plasma extérieur.

5. Pistolet à plasma selon la revendication 1, dans lequel lesdits moyens générateurs de flux magnétique comprennent au moins un aimant permanent (17).

6. Pistolet à plasma selon la revendication 1, dans lequel il est en outre prévu un boîtier (11) et dans lequel lesdits moyens cathodiques font partie de ce boîtier (11).

7. Pistolet à plasma selon la revendication 4, dans lequel la différence entre lesdites première et seconde tensions est maintenue pratiquement constante et dans lequel ladite seconde tension est maintenue approximativement au potentiel de terre, d'où il résulte un faisceau ionique ayant une densité extrêmement uniforme.

8. Pistolet à plasma selon la revendication 1, dans lequel un substrat (49) est disposé au-dessus de l'au moins une ouverture (45) prévue dans le diaphragme (43).

FIG. I

FIG. 2

FIG. 3